# EUROPEAN PATENT SPECIFICATION

(11) **EP 2 920 826 B1**
(45) Date of publication and mention of the grant of the patent: **14.03.2018**
(21) Application number: 13803192.7
(22) Date of filing: 08.11.2013
(51) Int. Cl.: H01L 41/113, H02N 2/18, G06M 1/10

(54) **ASSEMBLY FOR CONVERTING MECHANICAL WORK INTO ELECTRICAL ENERGY AND COUNTING DEVICE COMPRISING IT**
ANORDNUNG ZUR UMWANDLUNG VON MECHANISCHER ARBEIT IN ELEKTRISCHE ENERGIE UND ZÄHLVORRICHTUNG DAMIT
ENSEMBLE POUR CONVERTIR UN TRAVAIL MÉCANIQUE EN UNE ÉNERGIE ÉLECTRIQUE ET DISPOSITIF DE COMPTAGE COMPRENANT CELUI-CI

(30) Priority: 13.11.2012 DE 102012220697
(43) Date of publication of application: 23.09.2015
(73) Proprietor: Johnson Matthey Catalysts (Germany) GmbH, 96257 Redwitz (DE)
(72) Inventor: KLUMP, Stefan, 96215 Lichtenfels (DE); RÜTTEL, Martin, 96271 Grub am Forst (DE); VAN DER LINDEN, Klaus, 96257 Redwitz (DE)
(74) Representative: Nunn, Andrew Dominic
(86) International application number: PCT/GB2013/052946
(87) International publication number: WO 2014/076458

(56) References cited:
- DE-A1-102004 055 996
- JP-A- 2006 294 947
- US-A1- 2010 078 941

## Description

### Field of the Invention

The invention relates to a counting device comprising an assembly for the conversion of mechanical work into electrical energy comprising a bending transducer with a support in the form of a strip and with at least one piezoelectric layer attached thereto.

### Background of the Invention

The piezoelectric effect is exploited in the area of "energy harvesting" to convert mechanical work into electrical energy, which is then used for supplying electronic assemblies, such as for example sensors, in a virtually autonomous manner. The mechanical work is in this case typically "existing/present" in any case and is merely "harvested". In this way, for example, gas pressure variations in the air or solid-state vibrations present in buildings can be exploited in order to generate electrical energy by means of the piezoelectric effect.

The exploitation of the piezoelectric effect takes place in this case with the aid of so-called piezo elements, which are often formed as so-called bending transducers. These are beam-like components restrained at one end, the free ends of which are for example deflected by the effect of a mechanical force and made to vibrate.

US 2009/0322184 A1 discloses an assembly for energy generation with the aid of such a bending transducer. The deflection of the free end of the beam-like piezo element is enforced here by a pushrod, on which a number of tooth-like projections are arranged. If the pushrod is made to pass by the piezo element in the pushing direction, the free end of the piezo element is initially taken along with each and every projection and thereby deflected a little. The free end of the piezo element is subsequently released and swings back on account of its elasticity. This sequence is repeated when each projection is passed, so that, when there is a movement of the pushrod in the pushing direction, the free end is deflected multiple times, in accordance with the number of projections.

Although the amounts of electrical energy that can be generated with such devices are comparatively small, they are sufficient to supply simple electronic assemblies, such as for example sensors. A corresponding application possibility for this principle is that of measuring the tyre inflation pressure within a vehicle tyre with the aid of a corresponding sensor. The energy for the operation of the sensor and for a wireless data transmission of a sensor signal generated by the sensor to a receiver unit is in this case provided by a suitably formed piezo element, which converts either pressure variations or vibrations in the vehicle tyre into electrical energy for supplying the sensor.

Against this background, the invention is based on the object of providing a counting device including an assembly for the conversion of mechanical work into electrical energy that has an advantageous configuration.

### Summary of the Invention

The object with respect to the counting device is achieved according to the invention by a counting device comprising an assembly for converting mechanical work into electrical energy, which assembly comprising a bending transducer with a support in the form of a strip and with at least one piezoelectric layer attached thereto, wherein the support in the form of a strip is mounted at both ends and wherein an actuating mechanism is provided in such a way that, when the actuating mechanism is actuated, a mechanical force is exerted on the support in the longitudinal direction of the support and leads to arcuate bending of the bending transducer, and thereby to the generation of electrical energy, which counting device comprising an electronic indicator and an electronic assembly, for sensing actuations of the actuating mechanism and for controlling the electronic indicator, which assembly supplies electrical energy for the electronic assembly and the electronic indicator.. The dependent claims comprise partly advantageous and partly independently inventive developments of this invention. In particular, the assembly can comprise an electronic assembly, which, when in use, senses actuations of the actuating mechanism and controls an electronic indicator, wherein the assembly supplies electrical energy for the electronic assembly and the electronic indicator.

DE 102004055996 A1 discloses a flexural or bending actuator comprising an actuator drive which is formed by a flat carrier curved in one direction, which on its flat face, is arranged a piezoelement which is joined flush with the flat face of the carrier, and the length of the carrier face is altered/changed by applying a supply voltage to the piezoelement relative to another flat face of the carrier. The carrier is hardened on the second flat face, over the entire surface or in zones and especially in strips.

The skilled person will appreciate that the apparatus disclosed in DE 102004055996 A1 functions according to the reverse piezoelectric effect, i.e. wherein a physical change in the piezo element is brought about by application of a potential difference, i.e. an energy input, whereas the assembly of the present invention operates as an energy harvester according to the piezoelectric effect, wherein energy (an output) is derived from physical movement of the piezoelement. In use, therefore, the apparatus disclosed in DE 102004055996 A1 requires completely different circuitry to the energy harvester of the present invention. Accordingly, the apparatus disclosed in DE 102004055996 A1 is not suitable for use as an energy harvester. In any event, the assembly of the present invention can be distinguished by the electronic assembly, which, when in use, senses actuations of the actuating mechanism and controls an electronic indicator, wherein the assembly supplies electrical energy for the electronic assembly and the electronic indicator.

The assembly for use in the counting device according to the invention serves to convert mechanical work into electrical energy. It comprises a bending transducer with a support in the form of a beam or strip and with at least one piezoelectric layer attached thereto, the support in the form of a strip being mounted at both ends. Moreover, an actuating mechanism for manually coupling in mechanical work as and when required is provided in such a way that, when the actuating mechanism is actuated, a mechanical force is exerted on the support in the longitudinal direction of the support and leads to arcuate bending of the bending transducer, and thereby to the generation of electrical energy. On account of the mounting at both ends of the bending transducer, the ends thereof are permanently guided both during the bending and during the return to the initial state. The bending transducer is therefore not made to vibrate and no snap mechanisms with which one of the ends is captured and suddenly released again are provided, which on the one hand leads to very uniform loading of the bending transducer and on the other hand makes it possible for the assembly to be operated with very little to no noise.

The support is preferably produced from a composite material of fibreglass fabric and epoxy resin (FR4), and lead zirconate titanate (PZT) is preferably used as the material for the piezoelectric layers.

The object with respect to the counting device is also achieved by an assembly for converting mechanical work into electrical energy and comprising a bending transducer with a support in the form of a strip and with at least one piezoelectric layer attached thereto, wherein the support in the form of a strip is mounted in a floating manner. The floating mounting of the support in the form of a strip is regarded as an independent invention in its own right. The right to divide the application on the basis of the above statement of invention is therefore reserved.

On account of the floating mounting of the support, smaller movements of the support in relation to the mounting of the support are made possible and the mass of the bending transducer is virtually isolated from the mounting. In this way it is ensured that, in the event of shock effects occurring by chance, no bending of the bending transducer takes place, while the bending transducer is bent when the actuating mechanism is deliberately actuated. Since the assembly is for a counting device e.g. in pocket format, shock effects such as are caused when the counting device is carried on the body or is dropped on the ground generally do not lead to bending of the bending transducer, while actuation of the actuating mechanism that is performed deliberately and specifically by a user of the counting device leads to a bending of the bending transducer.

A counting device comprising an assembly of such a design is of advantage in particular whenever no energy store or energy buffer is provided and whenever it is intended for an electronic assembly not only to be supplied with the electrical energy generated but also activated by means of it when required. In this case, the activation takes place only when the actuating mechanism is actuated and not undesirably as a result of shock effects, vibrations or oscillations.

According to a particularly simple configuration of the floating mounting of the support in the form of a strip, at least one end of the same lies loosely and with play in a holder or receptacle (the terms holder or receptacle are used herein interchangeably). A depression or a groove in a housing wall serves here for example as the receptacle and the freedom of movement of the at least one end of the support in the form of a strip in the associated holder or receptacle that is provided by the play is preferably 10 µm to 500 µm in the longitudinal direction of the support. In an advantageous development, both ends of the support in the form of a strip respectively lie loosely in a receptacle, the support preferably being able in an initial state of the actuating mechanism, in which it is not actuated, to move in relation to the two receptacles by 10 µm to 500 µm in the longitudinal direction of the support, while the two receptacles are fixed in relation to one another.

It is also expedient if the support in the form of a strip has a slight, and in particular arcuate, pre-curvature. This predetermines the direction of the arcuate bending of the support in the form of a strip when there is actuation of the actuating mechanism, and consequently of the bending transducer, under the effect of a mechanical force in the longitudinal direction of the support. Alternatively, this desired predetermination may also be realized for example by the support being designed in such a way that the modulus of elasticity of the support changes transversely in stages or gradually relative to the longitudinal direction of the support.

In accordance with a preferred configuration of the counting device, precisely one piezoelectric layer is applied on the support in the form of a strip, the piezoelectric layer more preferably extending only over a middle region on the support in the form of a strip. On account of the use of only one piezoelectric layer, and consequently the use of a monomorphic bending transducer, the polarization of the piezoelectric layer when there is bending of the bending transducer can be used by means of a particularly simple transducer circuit to generate an electrical supply voltage for supplying an electronic assembly. In comparison with multimorphic bending transducers, it is possible for example to dispense with additional rectifier circuits. Furthermore, the necessary expenditure of force for the bending of the bending transducer is reduced when there is only one piezoelectric layer.

In addition, the piezoelectric layer is preferably applied to the support in the form of a strip in such a way that, when the actuating mechanism is actuated, this layer predominantly undergoes a tensile deformation and that the polarization of the piezoelectric layer under bending of the bending transducer is directed in the direction of the normal to the surface (in elementary physics, the so-called D31 principle), with the lower potential on the side facing the support, i.e. the positive side of the polarization is oriented outwards towards the side facing away from the support. This takes place by predetermining the bending direction, for example by means of an arcuate pre-curvature of the support, and by positioning the piezoelectric layer on the side of the support that is exposed to the tensile deformation. Such a configuration is of advantage, since many piezoelectric materials react differently to tensile loads than they do to compressive loads and/or since, with corresponding materials, the piezoelectric effect is often more pronounced under tensile deformation than under compressive deformation.

Also of advantage is a configuration of the bending transducer in which the piezoelectric layer of the bending transducer is positioned outside a neutral axis thereof. In this way, the entire piezoelectric layer respectively undergoes a deformation when there is bending of the bending transducer, so that the generation of a charge under bending of the bending transducer is particularly pronounced. Consequently, a higher energy density (energy per volume of piezo material) can be achieved with the same deformation of the bending transducer.

Also expedient is a configuration of the assembly in which the bending transducer comprises at least two electrodes, the electrodes being connected outside the end mountings of the support to conductors thereby to form an electrical connection between the piezoelectric layer of the bending transducer and a transducer circuit. As a result, the mounting and the contacting of the bending transducer are spatially separated relatively far from one another, so that relative movements of the support in relation to the mountings within the existing and intended freedom of movement do not impose any mechanical loading on the contacts.

Moreover, a preferred variant of the counting device assembly is one in which every fully performed actuation of the actuating mechanism is accompanied by the execution of a working cycle in which an electrical energy pulse, in particular an energy pulse with an energy content of a few 10 µJ to a few 100 µJ, is generated and used for supplying an electronic assembly, the energy content of an energy pulse being designed for a useful function of the electronic assembly to be performed once. The actuating mechanism is in this case designed for example in such a way that, when actuation occurs, a plunger is actively moved by a user against a spring over a certain displacement path and the spring is subsequently passively returned by the restoring force. In this case, the working cycle comprises both the displacing movement against the spring and the return of the plunger by the restoring force back into the initial position of the plunger. The displacing movement has the effect here of exerting a mechanical force on the bending transducer in the longitudinal direction of the support and the bending transducer being arcuately bent as a result. For example, the support in the form of a strip itself acts here as the spring. A corresponding electronic assembly should be understood in this connection as meaning for example a radio circuit, the useful function of which is that of generating in response to the feeding in of a corresponding energy pulse a pulse-like radio signal, which for example initiates the opening or closing of an automatic garage door.

The intended object of providing an advantageous counting device with an assembly of the type described above is achieved according to the invention by a counting device comprising an assembly according to the invention, characterized by an electronic indicator and by an electronic assembly, for sensing actuations of the actuating mechanism and for controlling the electronic indicator, which assembly supplies electrical energy for the electronic assembly and the electronic indicator.

The counting device, which is formed in particular as a counting device in a pocket format, has an assembly with one of the configurations described above. Furthermore, the counting device comprises an electronic indicator and a control unit, formed by the electronic assembly, for sensing actuations of the actuating mechanism and for controlling the electronic indicator. The electronic indicator is in this case provided in order to indicate a counter reading, and the assembly is provided for supplying the control unit and the electronic indicator. The energy supply takes place exclusively through the assembly, there are no further energy sources. The counting device is therefore autonomous, and in particular batteryless. With preference, no energy store is provided either.

Therefore, the counting device is, for example, a counting device that is carried in a pocket and has a simple indicator, in particular a bistable indicating element, by means of which a number or remaining number is indicated, preferably in the manner of a countdown. Accordingly, each time the actuating mechanism is actuated, the indicated numerical value is reduced by 1, so that the user can at any time read off from the indicator the still remaining number or residual number.

Also of advantage is a configuration of the counting device with an assembly in which every fully performed actuation of the actuating mechanism is accompanied by the execution of a working cycle in which an electrical energy pulse, in particular an energy pulse with an energy content of a few 10 µJ to a few 100 µJ, is generated and used for supplying the electronic assembly, the energy content of an energy pulse being designed for a useful function of the electronic assembly to be performed at least once. The working cycle is in this case made up of an active half-cycle and a passive half-cycle (see below), each of the two half-cycles, in particular the active half-cycle, that is to say for example when the plunger is actively depressed, being accompanied by the generation of a partial energy pulse, the energy content of which is already sufficient to start and perform the useful function of the electronic assembly comprising the control unit and the electronic indicator once.

A useful function is understood as meaning generally the full performance of a running cycle, the electronic assembly being designed exclusively for repeatedly carrying out the running cycle. In the case of a counting device, the useful function consists in particular of the changing of a count value stored in a memory, in particular a nonvolatile memory, by the count value 1 and the indication of the (changed) count value on the indicator. DE 10 2012 211 576.5, unpublished on the filing date of this application, discloses a metering device with such a counting device with an electronic assembly for carrying out a running cycle.

The useful function is in this case designed in particular in such a way that, as a result of the generation of an energy pulse or a partial energy pulse, the useful function is started and the counter reading of the electronic indicator is reduced by one unit.

In a preferred embodiment, the electronic assembly comprises a locking element, which prevents performance of the useful function being initiated by the passive half-cycle. With respect to the example of the counting device, this means that, when the actuating mechanism is actuated, the user for example moves a plunger against a spring or a build-up of gas pressure along a displacement path as far as a stop, which corresponds to the active half-cycle, and that subsequently, that is to say after letting go, the plunger is returned to its initial position on account of the restoring force of the spring or the restoring force due to the gas pressure, which corresponds to the passive half-cycle. As a result of each active half-cycle, the counter reading of the indicator is changed as intended by the value 1. However, each of the two half-cycles is accompanied by generation of a partial electrical energy pulse, which is suitable in principle for performing the useful function of the electronic assembly. In this case, the counting of the actuations is performed by means of a simple logic circuit, which responds to the energy pulses or partial energy pulses. If the plunger is thus kept longer in its position after the active half-cycle, and consequently the passive half-cycle is performed with a clear time lag, this results in the generation of two partial energy pulses that are separated in time from one another, which is suitable in principle for initiating further counting by the logic circuit. In order to prevent double counting caused as a result, the locking element is provided for the counting device, and is designed for example as a timer that locks the electronic assembly for a predetermined time period, for example 5s, after each counting, so that no further counting can take place in this time period. Alternatively, the locking element is for example realized by means of a simple diode. This makes use of the fact that the polarity of the energy pulse or partial energy pulse is reversed in the case of the passive half-cycle in comparison with the active half-cycle.

### Brief Description of the Drawings

Exemplary embodiments of the invention are explained in more detail below on the basis of a schematic drawing, in which:
- Figure 1: shows a counting device with an assembly for the conversion of mechanical work into electrical energy in a block diagram representation;
- Figure 2: shows the assembly with a bending transducer in a sectional representation; and
- Figure 3: shows the bending transducer in an enlarged detail.

Parts that correspond to one another are respectively provided with the same reference numerals in all of the figures.

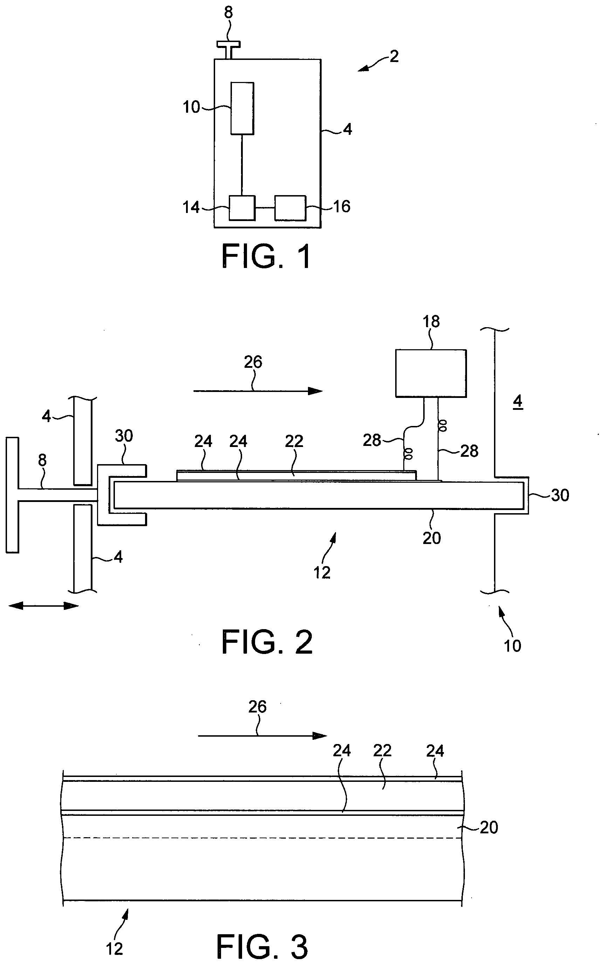

The counting device 2 described below by way of example and represented diagrammatically in Figure 1 has a housing 4 and is kept in a pocket format. A further part of the counting device 2 is an actuating mechanism, which when actuated is accompanied by a plunger 8 being moved in the direction of the housing 4 along a predetermined displacement path, whereby on the one hand a gas pressure is built up, with the aid of which a restoring force is built up, and whereby on the other hand mechanical work is coupled into an assembly 10 with a bending transducer 12, so that as a result the work performed by a user of the counting device 2 through the movement of the plunger 8 is at least partially converted into electrical energy. This energy is used for supplying an electronic assembly 14 with a counting logic and for supplying a bistable (LCD) indicating element 16.

The counting logic thereby counts backwards in the manner of a countdown from a starting value, each actuation of the actuating mechanism, that is to say each movement of the plunger 8 in the direction of the housing 4, being accompanied by generation of an energy pulse, on the basis of which the counting logic reduces the counter reading by one unit. Moreover, when there is a change in the counter reading, the bistable indicating element 16 is activated, so that it subsequently indicates the changed, and consequently current, counter reading.

In order to avoid undesired and erroneous double counts, after each change of the counter reading the counting logic is locked for a certain time with the aid of a timer, so that no changing of the counter reading takes place in this time period. It is assumed here that the user releases the plunger 8 again within this time period, the plunger being moved back into its initial position on account of a restoring force exerted by the assembly 10 on the plunger 8. With the aid of the locking of the counting logic, it is consequently prevented that the return of the plunger 8 leads to a changing of the counter reading.

The assembly 10 for the conversion of mechanical work into electrical energy is depicted in its basic form in Figure 2. It comprises the bending transducer 12 and a transducer circuit 18, with the aid of which a voltage picked off from the bending transducer 12 is converted into a supply voltage for the electronic assembly 14 on the one hand and for the indicating element 16 on the other. The transducer circuit 18 is, for example, part of the electronic assembly 14.

Part of the bending transducer 12 is a support 20 in the form of a strip (for example with the dimensions 25 mm × 80 mm × 0.42 mm) of a composite material comprising fibreglass and synthetic resin, on which a piezoelectric layer 22 (for example with the dimensions 24 mm × 28 mm × 0.25 mm) is adhesively bonded in a middle region on the upper side of the support 20, facing the transducer circuit 18. Moreover, vapour-deposited on the upper side of the support 20 on the one hand and on the upper side of the piezoelectric layer 22 on the other hand are metallic electrodes, the extent of which transversely to the longitudinal direction of the support 26 corresponds to the extent of the piezoelectric layer 22 transversely to the longitudinal direction of the support 26 or exceeds it. The electrodes 24 are connected in an electrically conducting manner to the transducer circuit 18 by way for example of simple wire connections 28. The wire connections 28 allow a movement of the bending transducer 12 in relation to the transducer circuit 18, which is for example accommodated on a simple circuit board fastened to the housing 4, without the contacts between the wire connections 28 and the electrodes 24 being subjected to mechanical loading.

The support 20 has a slightly arcuate curvature and is mounted at both ends. In this case, the support 20 lies with each of both ends loosely and with play in a holder 30, a receptacle being formed by a depression or groove in one of the walls of the housing 4 or a holding element, while the other holder 30 is provided by a profiled strip formed on the plunger 8 and reaching around the support 20. If the plunger 8 is thus moved in the longitudinal direction of the support 26 in the course of an actuation of the actuating mechanism, a mechanical force is exerted on the support 20 in the longitudinal direction of the support 26 after overcoming the play between the support 20 and the holders 30, whereby the support 20 arcuately bends. As a result of this, the piezoelectric layer 22 undergoes a tensile deformation, whereupon there forms a voltage that can be picked off from the piezoelectric layer 22.

On account of the play existing between the support 20 and the holders 30, the support 20 and the housing 4 of the counting device 2 are not rigidly coupled to one another, whereby shock effects such as are caused for example when the counting device 2 is carried in a pocket on the body while walking or shock effects such as occur when it is dropped on the ground or put down on a table lead to a movement of the support 20 in relation to the housing 4, but not to a bending of the bending transducer 12.

This achieves the effect that only specifically performed actuations of the actuating mechanism, in which the plunger 8 is moved specifically and over a minimum distance in the longitudinal direction of the support 26, lead to a bending of the bending transducer 12, and consequently to the generation of an electrical energy pulse. Miscountings of the counting logic on account of shock effects are thereby avoided.

The assembly 10 and the electronic assembly 14 are in this case preferably designed in such a way that even a displacement of only a few millimetres, for example even 2-4 mm, is accompanied by generation of sufficient energy for the performance of the useful function.

In the exemplary embodiment, the bending transducer 12 is configured as a monomorphic bending transducer 12 and accordingly has precisely one piezoelectric layer 22. In this case, the material thicknesses of the support 20 on the one hand and of the piezoelectric layer 22 on the other hand are made to match one another in such a way that the neutral axis of the bending transducer lies within the support 20, and consequently outside the piezoelectric layer 22, so that as a result of this, when there is a bending of the bending transducer 12, a tensile deformation occurs in the entire piezoelectric layer 22, whereby the piezoelectric effect is particularly pronounced.

### List of designations

- 2: Counting device
- 4: Housing
- 8: Plunger
- 10: Assembly
- 12: Bending transducer
- 14: Electronic assembly
- 16: Indicating element
- 18: Transducer circuit
- 20: Support
- 22: Piezoelectric layer
- 24: Electrode
- 26: Longitudinal direction of the support
- 28: Wire connection
- 30: Holder

## Claims

1. Counting device (2) comprising an assembly (10) for converting mechanical work into electrical energy, which assembly comprising a bending transducer (12) with a support (20) in the form of a strip and with at least one piezoelectric layer (22) attached thereto, wherein the support (20) in the form of a strip is mounted at both ends (30) and wherein an actuating mechanism (8, 30) is provided in such a way that, when the actuating mechanism (8, 30) is actuated, a mechanical force is exerted on the support (20) in the longitudinal direction of the support (26) and leads to arcuate bending of the bending transducer (12), and thereby to the generation of electrical energy, which counting device comprising an electronic indicator (16) and an electronic assembly (14), for sensing actuations of the actuating mechanism (8, 30) and for controlling the electronic indicator (16), which assembly (10) supplies electrical energy for the electronic assembly (14) and the electronic indicator (16)..

2. Counting device (2) according to claim 1, wherein the support (20) in the form of a strip is mounted in a floating manner (30).

3. Counting device (2) according to claim 1 or 2, wherein at least one end of the support (20) in the form of a strip lies loosely and with play in a holder (30).

4. Counting device (2) according to claim 3, wherein the freedom of movement that is provided by the play is 10 µm to 500 µm in the longitudinal direction of the support (26).

5. Counting device (2) according to any preceding claim, wherein the support (20) in the form of a strip has an arcuate pre-curvature.

6. Counting device (2) according to any preceding claim, wherein precisely one piezoelectric layer (22) is applied on the support (20) in the form of a strip, wherein the piezoelectric layer (22) undergoes a tensile deformation when the actuating mechanism (8,30) is actuated.

7. Counting device (2) according to any preceding claim, wherein the piezoelectric layer (22) of the bending transducer (12) is positioned outside a neutral axis of the bending transducer (12).

8. Counting device (2) according to any preceding claim, wherein the bending transducer (12) comprises at least two electrodes (24), the electrodes (24) being connected outside the end mountings (30) of the support (20) to conductors (28) for the forming of an electrical connection (28) between the piezoelectric layer (22) of the bending transducer (12) and a transducer circuit (18).

9. Counting device (2) according to any preceding claim, wherein every fully performed actuation of the actuating mechanism (8, 30) is accompanied by the execution of a working cycle in which an electrical energy pulse is generated and used for supplying an electronic assembly (14), the energy content of an energy pulse being designed for a useful function of the electronic assembly (14) to be performed once.

10. Counting device (2) according to claim 9, wherein an energy content of the electrical pulse energy is a few 10 µJ to a few 100 µJ.

11. Counting device (2) according to Claim 9, wherein the working cycle is made up of an active half-cycle and a passive half-cycle, at least the active half-cycle being accompanied by the generation of an electrical energy pulse, the energy content of which is sufficient to perform a useful function of the electronic assembly (14) once.

12. Counting device (2) according to Claim 11, wherein the electronic assembly (14) is designed in such a way that performance of the useful function is locked by the passive half-cycle.

## Patentansprüche

1. Zählvorrichtung (2), aufweisend eine Anordnung (10) zur Umwandlung von mechanischer Arbeit in elektrische Energie, wobei die Anordnung einen Biegewandler (12) mit einem Träger (20) in Form eines Streifens und mit mindestens einer daran angebrachten piezoelektrischen Schicht (22) aufweist, wobei der Träger (20) in Form eines Streifens an beiden Enden (30) montiert ist und wobei ein Betätigungsmechanismus (8, 30) derart vorgesehen ist, dass, wenn der Betätigungsmechanismus (8, 30) betätigt wird, eine mechanische Kraft in Längsrichtung des Trägers (26) auf den Träger (20) ausgeübt wird und zu einem bogenförmigen Biegen des Biegewandlers (12) und damit zur Erzeugung von elektrischer Energie führt, wobei die Zählvorrichtung eine elektronische Anzeigevorrichtung (16) und eine elektronische Anordnung (14) zum Erfassen von Betätigungen des Betätigungsmechanismus (8, 30) und zum Steuern der elektronischen Anzeigeeinheit (16) aufweist, wobei die Anordnung (10) elektrische Energie für die elektronische Anordnung (14) und die elektronische Anzeigevorrichtung (16) liefert.

2. Zählvorrichtung (2) gemäß Anspruch 1, wobei der Träger (20) in Form eines Streifens schwimmend (30) montiert ist.

3. Zählvorrichtung (2) gemäß Anspruch 1 oder 2, wobei mindestens ein Ende des Trägers (20) in Form eines Streifens lose und mit einem Spiel in einem Halter (30) liegt.

4. Zählvorrichtung (2) gemäß Anspruch 3, wobei die Bewegungsfreiheit, die durch das Spiel vorgesehen wird, 10 µm bis 500 µm in der Längsrichtung des Trägers (26) beträgt.

5. Zählvorrichtung (2) nach einem der vorhergehenden Ansprüche, wobei der Träger (20) in Form eines Streifens eine bogenförmige Vorkrümmung aufweist.

6. Zählvorrichtung (2) nach einem der vorhergehenden Ansprüche, wobei genau eine piezoelektrische Schicht (22) auf dem Träger in Form eines Streifens aufgebracht ist, wobei die piezoelektrische Schicht (22) eine Zugverformung erfährt, wenn der Betätigungsmechanismus (8, 30) betätigt wird.

7. Zählvorrichtung (2) nach einem der vorhergehenden Ansprüche, wobei die piezoelektrische Schicht (22) des Biegewandlers (12) außerhalb einer Biegeachse des Biegewandlers (12) positioniert ist.

8. Zählvorrichtung (2) nach einem der vorhergehenden Ansprüche, wobei der Biegewandler (12) mindestens zwei Elektroden (24) aufweist, wobei die Elektroden (24) außerhalb der Endhalterungen (30) des Trägers (20) zum Bilden einer elektrischen Verbindung (28) zwischen der piezoelektrischen Schicht (22) des Biegewandlers (12) und einer Wandlerschaltung (18) mit Leitern (28) verbunden ist.

9. Zählvorrichtung (2) nach einem der vorhergehenden Ansprüche, wobei jede vollständig ausgeführte Betätigung des Betätigungsmechanismus (8, 30) von der Ausführung einer Arbeitsperiode begleitet wird, bei der ein elektrischer Energieimpuls erzeugt und für die Versorgung einer elektronischen Anordnung (14) verwendet wird, wobei der Energiegehalt eines Energieimpulses für eine nützliche Funktion der elektronischen Anordnung (14) zur einmaligen Ausführung ausgelegt ist.

10. Zählvorrichtung (2) gemäß Anspruch 9, wobei ein Energiegehalt der elektrischen Impulsenergie wenige 10 µJ bis wenige 100 µJ beträgt.

11. Zählvorrichtung (2) gemäß Anspruch 9, wobei die Arbeitsperiode aus einer aktiven Halbperiode und einer passiven Halbperiode besteht, wobei zumindest die aktive Halbperiode von der Erzeugung eines elektrischen Energieimpulses begleitet ist, dessen Energiegehalt ausreichend ist, um einmalig eine nützliche Funktion der elektronischen Anordnung (14) auszuführen.

12. Zählvorrichtung (2) gemäß Anspruch 11, wobei die elektronische Anordnung (14) derart ausgeführt ist, dass die Ausführung der nützlichen Funktion durch die passive Halbperiode blockiert wird.

## Revendications

1. Dispositif de comptage (2) comprenant un montage (10) permettant de convertir un travail mécanique en énergie électrique, ledit montage comprenant un transducteur de courbure (12) avec un support (20) sous la forme d'une bande et avec au moins une couche piézoélectrique (22) fixée sur celui-ci, dans lequel le support (20) sous la forme d'une bande est monté au niveau de deux extrémités (30) et dans lequel un mécanisme d'actionnement (8, 30) est fourni de telle manière que, lorsque le mécanisme d'actionnement (8, 30) est actionné, une force mécanique est exercée sur le support (20) dans la direction longitudinale du support (26) et entraîne une courbure en arc du transducteur du courbure (12), ce qui crée de l'énergie électrique, ledit dispositif de comptage comprenant un affichage électronique (16) et un montage électronique (14), permettant de détecter des actionnements du mécanisme d'actionnement (8,30) et permettant de commander l'affichage électronique (16), ledit montage (10) fournissant de l'énergie électrique pour le montage électronique (14) et l'affichage électronique (16).

2. Dispositif de comptage (2) selon la revendication 1, dans lequel le support (20) sous la forme d'une bande est monté de manière flottante (30).

3. Dispositif de comptage (2) selon la revendication 1 ou 2, dans lequel au moins une extrémité de support (20) sous la forme d'une bande repose librement et avec du jeu dans un dispositif de retenue (30).

4. Dispositif de comptage (2) selon la revendication 3, dans lequel la liberté de mouvement qui est fournie par le jeu est comprise entre 10 µm et 500 µm dans la direction longitudinale du support (26).

5. Dispositif de comptage (2) selon l'une quelconque des revendications précédentes, dans lequel le support (20) sous la forme d'une bande présente une précourbure en arc.

6. Dispositif de comptage (2) selon l'une quelconque des revendications précédentes, dans lequel exactement une couche piézoélectrique (22) est appliquée sur le support (20) sous la forme d'une bande, dans lequel ladite couche piézoélectrique (22) subit une déformation en traction lorsque le mécanisme d'actionnement (8, 30) est actionné.

7. Dispositif de comptage (2) selon l'une quelconque des revendications précédentes, dans lequel la couche piézoélectrique (22) du transducteur de courbure (12) est positionnée à l'extérieur d'un axe neutre du transducteur de courbure (12).

8. Dispositif de comptage (2) selon l'une quelconque des revendications précédentes, dans lequel le transducteur de courbure (12) comprend au moins deux électrodes (24), lesdites électrodes (24) étant raccordées, à l'extérieur des montures d'extrémité (30) du support (20), à des conducteurs (28) afin de former un raccordement électrique (28) entre la couche piézoélectrique (22) du transducteur de courbure (12) et un circuit de transduction (18).

9. Dispositif de comptage (2) selon l'une quelconque des revendications précédentes, dans lequel chaque actionnement entièrement mis en oeuvre du mécanisme d'actionnement (8, 30) est accompagné de l'exécution d'un cycle de travail au sein duquel une impulsion d'énergie électrique est générée et utilisée pour alimenter un montage électronique (14), la quantité d'énergie d'une impulsion d'énergie étant conçue pour une fonction utile du montage électronique (14) destinée à être mise en oeuvre une fois.

10. Dispositif de comptage (2) selon la revendication 9, dans lequel une quantité d'énergie de l'impulsion d'énergie électrique est comprise entre quelques dizaines de µJ et quelques centaines de µJ.

11. Dispositif de comptage (2) selon la revendication 9, dans lequel le cycle de travail est constitué d'un demi-cycle actif et d'un demi-cycle passif, au moins le demi-cycle actif étant accompagné de la génération d'une impulsion d'énergie électrique, dont la quantité d'énergie est suffisante pour mettre en oeuvre une fois une fonction utile du montage électronique (14).

12. Dispositif de comptage (2) selon la revendication 11, dans lequel le montage électronique (14) est conçu de telle manière qu'une mise en oeuvre de la fonction utile est verrouillée par le demi-cycle passif.
